(19) Europäisches Patentamt / European Patent Office / Office européen des brevets

(11) **EP 3 179 717 B1**

(12) **EUROPEAN PATENT SPECIFICATION**

(45) Date of publication and mention
of the grant of the patent:
**27.11.2019 Bulletin 2019/48**

(51) Int Cl.:
*H04N 9/31* *(2006.01)*    *H01S 3/10* *(2006.01)*

(21) Application number: **16202105.9**

(22) Date of filing: **05.12.2016**

(54) **PROJECTING DEVICE**

PROJEKTIONSVORRICHTUNG

DISPOSITIF DE PROJECTION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.12.2015 JP 2015238748**

(43) Date of publication of application:
**14.06.2017 Bulletin 2017/24**

(73) Proprietor: **Funai Electric Co., Ltd.
Daito
Osaka 574-0013 (JP)**

(72) Inventor: **SHIMIZU, Shinya
Daito, Osaka 574-0013 (JP)**

(74) Representative: **Becker Kurig Straus
Patentanwälte
Bavariastrasse 7
80336 München (DE)**

(56) References cited:
**US-A1- 2010 265 278    US-A1- 2015 260 984
US-A1- 2015 333 478**

**Description**

Field of the Invention

The present invention relates to a projecting device, and in particular, to a projecting device that is used for a head up display (hereinafter referred to as HUD) device and the like.

Description of Related Art

Conventionally, there exist projecting devices or projectors that display an image by irradiating laser beams of a red component, a green component and a blue component (hereinafter mentioned as RGB). Such projectors perform dimming by controlling laser beam sources that output the laser beams of RGB. For example, Patent Document 1 (Japanese Patent-Laid Open No. 2009-94315) discloses a light source device that, within a region of light amount that the output thereof is measureable by photo diodes, estimates a threshold value of driving current with which light emission becomes unstable from the measured result. The light source device then performs dimming by controlling the laser beam sources within a region that the driving current is greater than or equal to the estimated threshold value.

However, the output of the laser beam sources becomes not only unstable but also hard to be detected by the photo diodes in the region near or below the threshold value, because the region is a border of the LED (Light Emitting Diode) emission region and the LD (Laser Diode) emission region. Even for an image with the same color, when dimming is performed to reduce the luminance of the image, it is necessary to reduce the output of the laser beams of RGB at the same ratio. When the output is reduced at the same ratio, the threshold value of a laser beam having the lowest output is reached first. Thus, the laser beam sources of Patent Document 1 have a problem that the dimmable range is limited when laser beams of RGB are used.

US 2015/333478 A1 discloses a method of operating a laser comprising defining an intensity value for a light beam which is to be output from the laser, determining if the defined intensity value is greater than, or less than, a threshold intensity for the laser, wherein the threshold intensity is the intensity of the light which is output from the laser when the input current to the laser is equal to the threshold current of the laser, wherein the threshold current of the laser is an input current value below which the laser would operate in its light emitting region and equal to, or above which, the laser will operate in its laser region, operating the laser using current from at least a DAC current source if the defined intensity value is greater than the threshold intensity.

US 2015/260984 A1 discloses a laser scanning device having a dimmer unit equipped with a first light detection unit that modulates the light intensity of composite laser light emitted from a composite laser light emission unit, and detecting the light intensity of the composite laser light before entering the Dimmer unit. A second light detection unit detects the light intensity of the composite laser light after entering the Dimmer unit. The light intensity characteristic for each color in the composite laser light emission unit is calculated on the basis of the light intensity detected by the first light detection unit.

SUMMARY OF THE INVENTION

The present invention is provided by appended claim 1. Beneficial embodiments are provided by the dependent claims. The following disclosure serves a better understanding of the invention. Accordingly, the present disclosure is to address the abovementioned issue, and provides a projecting device or projector that is capable of easing the limitation of the dimmable range even laser beams of a plurality of different color components are used and of performing desirable dimming.

BRIEF DESCRIPTION OF THE DRAWINGS

FIG. 1 is a diagram illustrating a disposition example of an HUD device according to the first embodiment of the present invention.
FIG. 2 is a diagram illustrating an example of the scenery that the user sees through the front glass.
FIG. 3 is a diagram illustrating a configuration example of the HUD device according to the first embodiment.
FIG. 4 is a diagram illustrating an example of output ratios of the laser beams constituting the white balance according to the first embodiment.
FIG. 5 is a diagram illustrating an example of usable ranges of the laser beam sources without the pulse-driving according to a comparative example.
FIG. 6 is a diagram illustrating an example of usable ranges of the laser beam sources with the pulse-driving according to the first embodiment.

FIG. 7A-7C are diagrams illustrating an example of driving waveforms of the plurality of laser beam sources according to the first embodiment.

FIG. 8 is a diagram describing the effect of the first embodiment.

FIG. 9 is a diagram illustrating a configuration example of an HUD device according to the second embodiment.

FIG. 10A-10C are diagrams illustrating an example of driving waveforms of the plurality of laser beam sources according to the second embodiment.

FIG. 11 is a diagram illustrating an example of usable ranges of the laser beam sources with the pulse-driving according to the second embodiment.

FIG. 12 is a block diagram illustrating a hardware configuration of an HUD device according to the third embodiment.

FIG. 13 is a diagram describing change of the IL characteristic of a laser beam source due to temperature change.

FIG. 14 is a diagram illustrating numerical examples of duty, etc. under the high temperature according to the third embodiment.

FIG. 15 is a diagram illustrating numerical examples of duty change with respect to temperatures according to the third embodiment.

FIG. 16 is a flow chart describing the operations of the projector according to the third embodiment.

DETAILED DESCRIPTION OF THE EMBODIMENTS

Embodiments of the present disclosure are described below based on accompanying drawings. The embodiments described below are intended to illustrate a comprehensive or specific example. The numerical values, the shapes, the material, the components, the configuration and the connection form of the components set forth in the following embodiments are only examples, and should not be construed as limitations to the disclosure. In addition, regarding the components in the following embodiments, elements that are not recited in the independent claims are described as arbitrary components.

First Embodiment

The projector of the present invention is described using an HUD device as an example below. The HUD device is a system that displays virtual images beyond a windshield of an automobile (outside of the automobile) so as to display images inside the view of the user (driver) by projecting the images on the windshield.

Overall Configuration

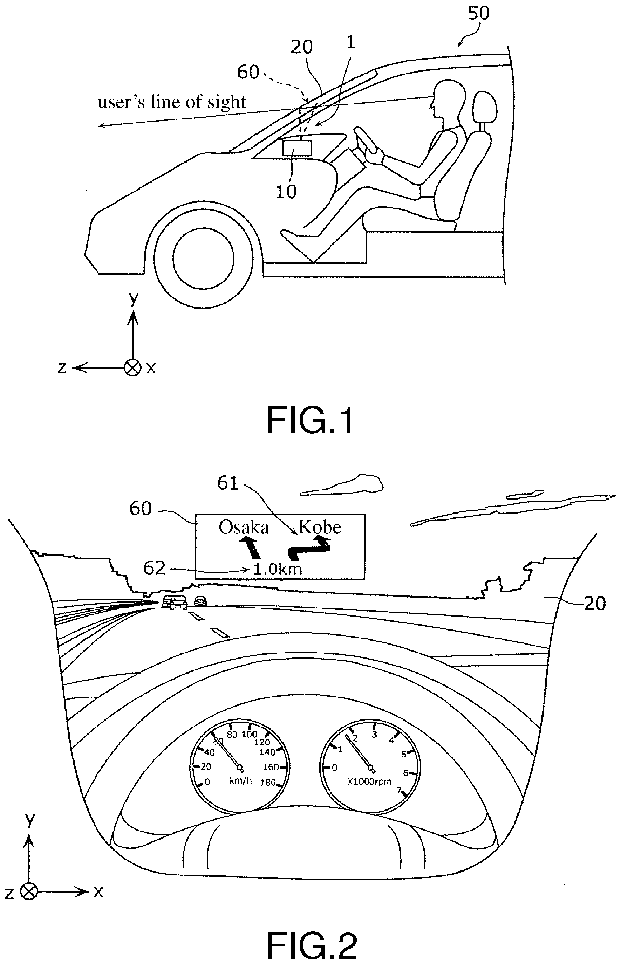

FIG. 1 is a schematic diagram illustrating a disposition example of an HUD device according to the first embodiment of the present invention. As shown in FIG. 1, the HUD device 1 includes a projector 10 and a combiner 60 (constituting a transparent display plate).

The projector 10 is disposed in a transport machine such as an automobile 50, and, for example, disposed on the dashboard of the automobile 50. The combiner 60 is a display surface disposed on a part of a windshield 20 of the automobile 50. The projector 10 projects an image on the combiner 60 by irradiating light to the combiner 60. The combiner 60 includes a polarization element, a wavelength selection element and a half mirror, etc., so the displayed image projected by the projector 10 is superimposed on to the scenery outside the automobile 50. In addition, the windshield 20 itself may have the function of the combiner 60.

FIG. 2 is a diagram illustrating an example of the scenery that the user sees through the windshield. As mentioned above, the combiner 60 is disposed on the windshield 20. The image projected by the projector 10 is displayed on the combiner 60. As shown in FIG. 2, the projector 10 has a function to display information relating to car navigation (route information to the destination, for example) or information regarding the automobile (fuel consumption information, for example), etc. For example, the projector 10 displays an image (an example of a content image) that illustrates a route information to the destination 61 ("Osaka", "Kobe" and arrows representing the respective corresponding route) or distance information to the destination 62 ("1.0 km") on the combiner 60. The user can obtain useful information related to driving without averting the eyes while driving the automobile 50 because the image projected by the projector 10 is displayed in the front scenery as shown in FIG. 2.

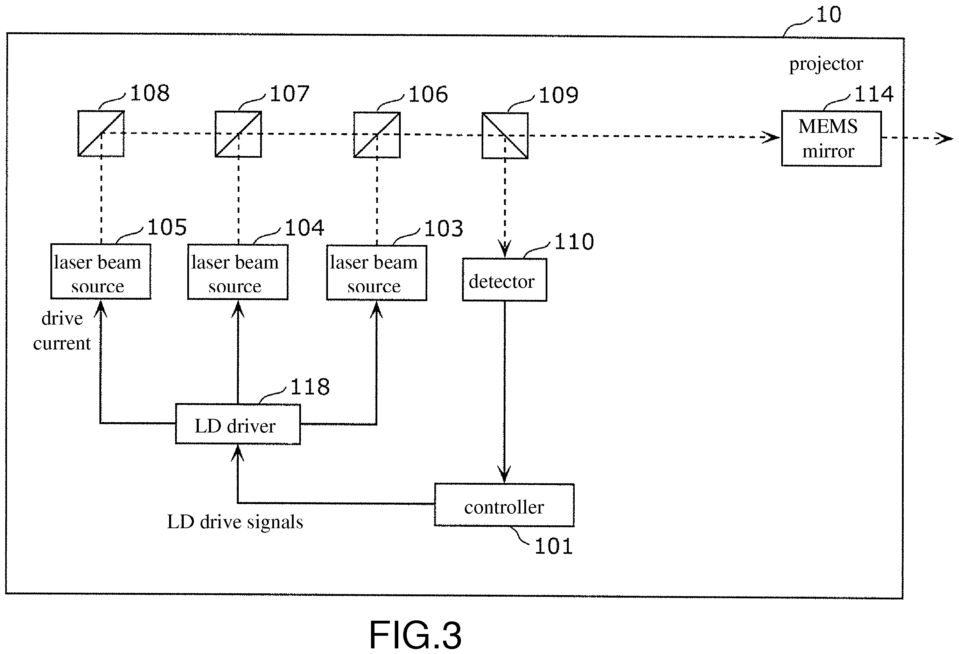

FIG. 3 is a diagram illustrating a configuration example of the HUD device according to the first embodiment.

The projector (projecting device) 10 is a projector of laser scan type. The outputs emitted from laser beam sources 103 to 105 of RGB components are synthesized and scanned by a MEMS (Micro Electro-Mechanical System) mirror 114. Then, a synthesized image is projected to a screen such as the combiner 60. Specifically, the projector 10 is a projector that displays an image by irradiating laser beams, and includes a controller 101, the laser beam sources 103 to 105, beam splitters 106 to 109, a detector 110, the MEMS mirror 114 and an LD driver 118.

The controller 101 is, for example, an APC (Automatic Power Control) controller, and controls the output of the laser beam sources 103 to 105. The controller 101 controls the irradiation of laser beams of the laser beam sources 103 to 105 by controlling the LD driver 118. Specifically, in accordance with the scan timing of the image by the MEMS mirror 114, the controller 101 controls the LD driver 118 to irradiate laser beams, the color of which corresponds to each pixel of the image, from the laser beam sources 103 to 105. The controller 101 makes the laser beam sources 103 to 105 irradiate target outputs by referring to the light amounts of the laser beams detected by the detector 110.

In this embodiment, by pulse-driving at least one of the plurality of the laser beam sources, the controller 101 reduces the average of the minimum value of the output (the minimum output) of laser beam of at least one laser beam source, compared to the case without pulse-driving (continuous driving). As the at least one laser beam source, the controller 101 pulse-drives a laser beam source having the lowest output based on that the light beams (laser beams) are respectively driven with a predetermined output (for example, based on a white balance ratio). Here, the plurality of color components are a red component, a green component and a blue component, and the abovementioned at least one laser beam source is the laser beam source of the blue component. That is, the controller 101 reduces the average of the minimum value of the output (the minimum output) of the laser beam of the laser beam source 103 by pulse-driving at least the laser beam source 103 of the blue component among the laser beam sources 103 to 105. Here, the controller 101 pulse-drives the laser beam source 103 with a duty ratio of 0.5 (duty 50%), for example.

The laser beam sources 103 to 105 are an example of the plurality of light emitting parts (i.e., the light source), and are light sources each of which outputs a laser beam (light beam) of a different color component. In this embodiment, the laser beam source 103 is a laser diode, and a laser beam of the blue component outputted from the laser diode is reflected to be coaxial to laser beams of other color components by the beam splitter 106 and then is inputted to the MEMS mirror 114. The laser beam source 104 is a laser diode, and a laser beam of the green component outputted from the laser diode is reflected to be coaxial to laser beams of other color components by the beam splitter 106 and then is inputted to the MEMS mirror 114. The laser beam source 105 is a laser diode, and a laser beam of the red component outputted from the laser diode is reflected to be coaxial to laser beams of other color components by the beam splitter 106 and then is inputted to the MEMS mirror 114.

The detector 110 is, for example, a photo diode and detects the light amount of a portion of the laser beam that is outputted by each of the laser beam sources 103 to 105 and reflected by the beam splitter 109.

The MEMS mirror 114 projects an image toward the combiner 60 by directing the merged (synthesized) laser beams coaxially reflected by the beam splitters 106 to 108. Also, the MEMS mirror 114 performs high-speed scan in the horizontal direction by resonant driving, and performs low-speed scanning in the vertical direction by DC driving.

The LD driver 118 adjusts the light amounts of the laser beam sources 103 to 105 by supplying driving currents to the laser beam sources 103 to 105 under the control of the controller 101.

Operations of Projector

Next, operations of the projector 10 are described. Featured operations among the operations of the projector 10 are mainly described below.

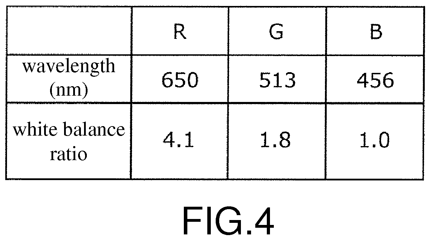

FIG. 4 is a diagram illustrating an example of output ratios of laser beams constituting the white balance according to the first embodiment. The wavelength of the laser beam of the blue component outputted from the laser beam source 103 is, for example, 456nm. The wavelength of the laser beam of the green component outputted from the laser beam source 104 is, for example, 513nm. The wavelength of the laser beam of the red component outputted from the laser beam source 105 is, for example, 650nm. The wavelength of each color component is an example and may be different from the wavelength shown in FIG. 4. In this case, the output ratios of the laser beams constituting the white balance are that the green component (also referred to as G) is 1.8 and the red component (also referred to as R) is 4.1 with respect to the blue component (also referred to B) as 1. Thus, as shown in FIG. 4, the laser beam of the blue component has a relatively low output to generate the white color (to constitute the white balance).

To simplify the description below, it is assumed that the synthetic light becomes the white color when the RGB ratio is 4:2:1.

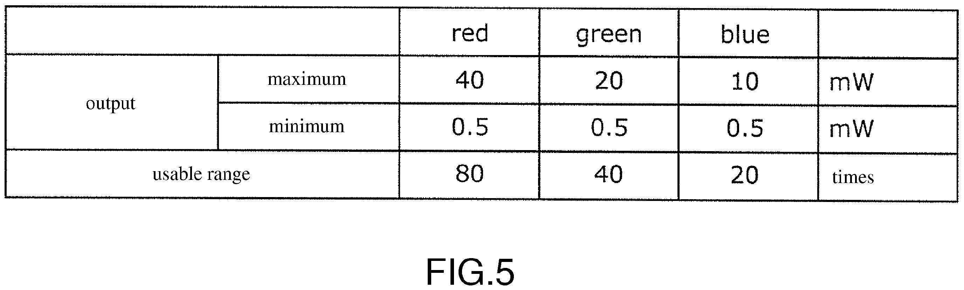

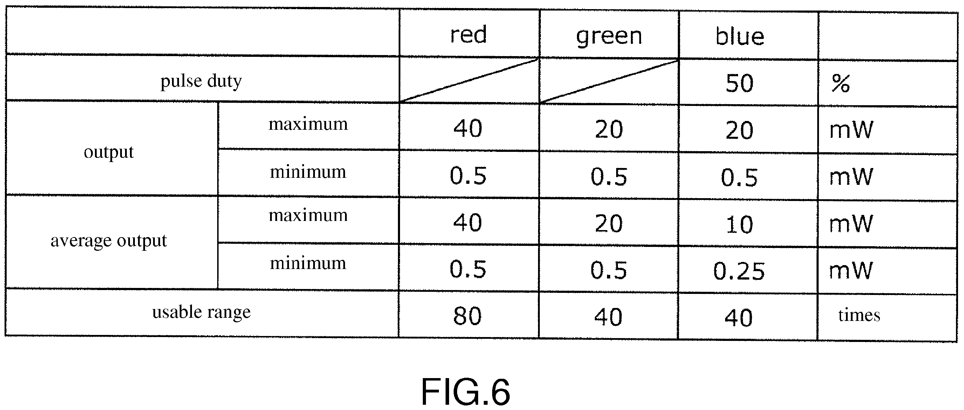

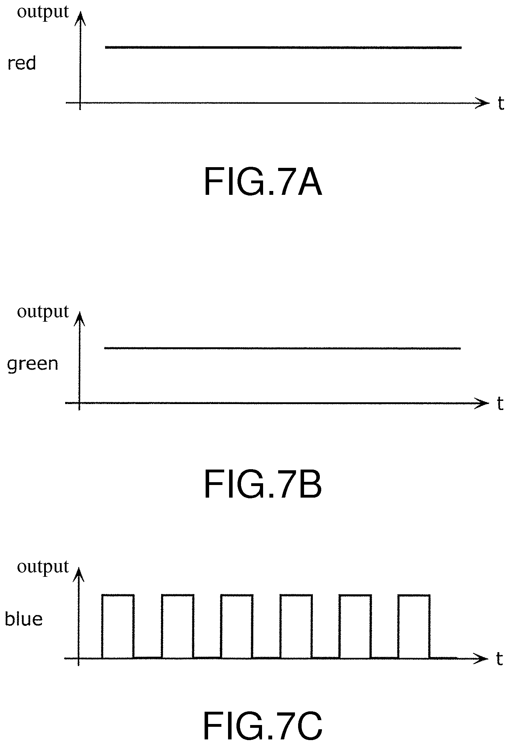

FIG. 5 is a diagram illustrating an example of usable ranges of the laser beam sources without pulse-driving according to a comparative example. FIG. 6 is a diagram illustrating an example of usable ranges of the laser beam sources with pulse-driving according to the first embodiment. FIG. 7 is a diagram illustrating an example of driving waveforms of the plurality of laser beam sources according to the first embodiment.

Firstly, a comparative example that all the laser beam sources 103 to 105 are driven with continuous wave (CW) rather than pulse-driven is described. As mentioned above, the output of the laser beam sources 103 to 105 becomes not only unstable but also hard to be detected by the photo diodes in the region near or below the threshold value, with which the light emission becomes unstable, because the region is a border of the LED emission region and the LD emission region. Therefore, the output at the threshold value is the lower limit used by the laser beam sources 103 to 105.

For example, it is necessary to reduce the outputs of the laser beam sources 103 to 105 by the same ratio to dim to make the light emission the white color and low luminance. When the outputs of the laser beam sources 103 to 105 are reduced by keeping the same ratio, the laser beam source 103 of the blue component which has the lowest output among the ratio reaches the threshold value first. If dimming is performed for low luminance under such a condition, a color distortion occurs because the output of the laser beam source 103 of the blue component becomes unstable and the white light can not be correctly synthesized.

In FIG. 5, the output ranges of the laser beam sources 103 to 105 defined by the maximum value (the maximum output) and the minimum value (the minimum output) of the output are shown. The synthesized light of the maximum outputs of the laser beam sources 103 to 105 becomes the white light. The minimum output indicates the output at the respective threshold value for each of the laser beam sources 103 to 105, and is approximately the same value (0.5mW) for all the laser beam sources 103 to 105. The usable range of the laser beam sources is calculated by a ratio of the maximum output and the minimum output (the maximum output / the minimum output), and the larger the resulted value is, the larger the dimming range can be made. The usable range is 80 times for the laser beam source 105 of the red component, 40 times for the laser beam source 104 of the green component, and 20 times for the laser beam source 103 of the blue component ("blue" in the FIG. 5), which is the smallest of the three. Since it is necessary to maintain the RGB ratio to maintain the white balance, the dimmable range is limited by the usable range of the laser beam source 103 of the blue component, and 1/20 is the limit.

In this embodiment, the laser beam source 105 shown in FIG. 7A, which outputs a laser beam of the red component, and the laser beam source 104 shown in FIG. 7B, which outputs a laser beam of the green component, are driven with CW (continuous wave). The laser beam source 103 shown in FIG. 7C, which outputs a laser beam of the blue component, is pulse-driven. FIG. 7C shows an example that the laser beam source 103 is pulse-driven with the duty ratio of 0.5 (duty 50%). Here, by setting the pulse used for the pulse-driving to a high frequency value of several tens of MHz or higher, the output is recognized as an averaged output (power) by human eyes. For example, with the pulse peak power of 20mW and duty ratio of 50%, the average output (average power) is 10mW. This case is explained below using numerical examples shown in FIG. 6.

FIG. 6 shows numerical examples when the laser beam source 103 which outputs the blue laser beam is pulse-driven (duty 50%, the pulse peak power to be doubled). As shown in FIG. 6, since the duty is 50%, the minimum output (the average of the minimum values of the output) can be 0.25mW even though the minimum value of the output (the minimum output) of the laser beam source 103 of the blue component is 0.5mW. Moreover, the rated output of the laser beam source 103 of the blue component is still capable of being greater in view of the maximum output of 10mW shown in FIG. 5, so the maximum power (the average of the maximum value of the output) can be 10mW by making the maximum output (maximum pulse peak power) double, i.e., 20mW. Thereby, the usable range of the laser beam source 103 of the blue component is increased about 40 times. Even though this usable range is less than the usable range of the laser beam source 105 of the red component, which is 80 times, this usable range is approximately equal to the usable range of the laser beam source 104 of the green component, i.e., 40 times. Accordingly, the dimmable range can be widened to 1/40 when the pulse-driving shown in FIG. 6 is performed, compared to 1/20 without the pulse-driving as described in FIG. 5.

In this way, the usable range of the laser beam source 103 of the blue component can be widened by pulse-driving the laser beam source 103 of the blue component so as to make the maximum output (maximum pulse peak power) double. Thereby, the limitation of the dimmable ranges of the laser beam sources 103 to 105 is eased.

Effects

As described above, according to this embodiment, it is possible to realize the projector 10 with which the limitation of the usable range can be eased even though laser beam sources of different color components are used and desirable dimming can be performed.

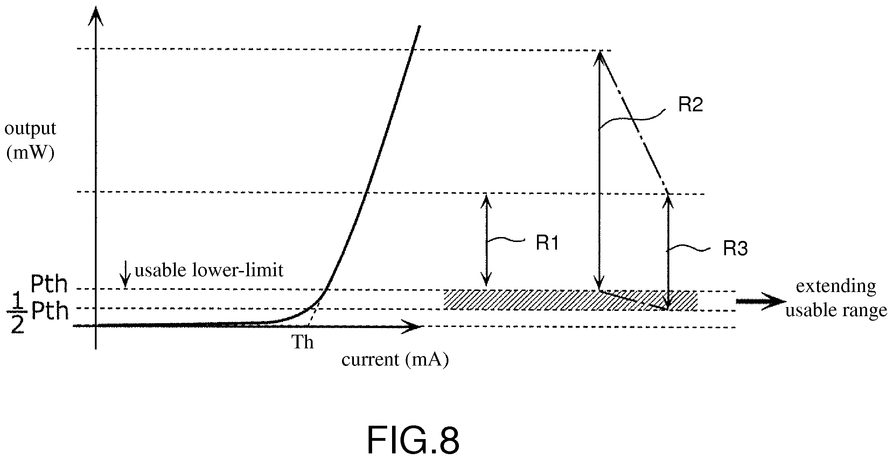

FIG. 8 is a diagram describing the effects of the first embodiment. FIG. 8 shows the IL (driving current vs light output) characteristic of the laser beam source 103. Because the output (Pth) of the laser beam source 103 becomes unstable near the threshold value Th shown in FIG. 8, the laser beam source 103 avoids using the output near the threshold value Th. The range R1 shows the usable range of the comparative example, the range R2 shows the usable range of the this embodiment and the range R3 shows the usable range when the laser beam source 103 is pulse-driven with a duty of 50%.

As shown in FIG. 8, according to the projector 10 of this embodiment, the lower-limit value of the range R3 can be lowered and the apparent threshold value Th can be made in half because the average output (average power) becomes 1/2 (1/2 Pth) by pulse-driving the laser beam source 103 of the blue component with a duty of 50%. In this way, the usable range can be extended to the lower output (lower power) side compared to the range R1 of the comparative example, and the limitation of the dimmable range is eased.

Thus, according to the projector 10 of this embodiment, the maximum output after dimming can be made equal to the maximum output of the case without the pulse-driving by changing the duty ratio, and the lower-limit power (the minimum power of the output) of the laser beam source 103 of the blue component can be stably reduced compared to the case without the pulse-drive. Thereby, the dimmable range can be extended to a lower range since the minimum values of the outputs usable by each of the laser beam sources of RGB can be made closer, and a lower output as a whole (i.e., RGB) can be achieved compared to the case without the pulse-driving.

Second Embodiment

The first embodiment describes the case that the laser beam source of blue component among the laser beam sources of RGB, i.e., one of the laser beam sources of the plurality of different color components, is pulse-driven, but the present invention is not limited thereto. It is possible to pulse-drive two of the laser beam sources among the laser beam sources of the plurality of different color components. An example of this case is described below.

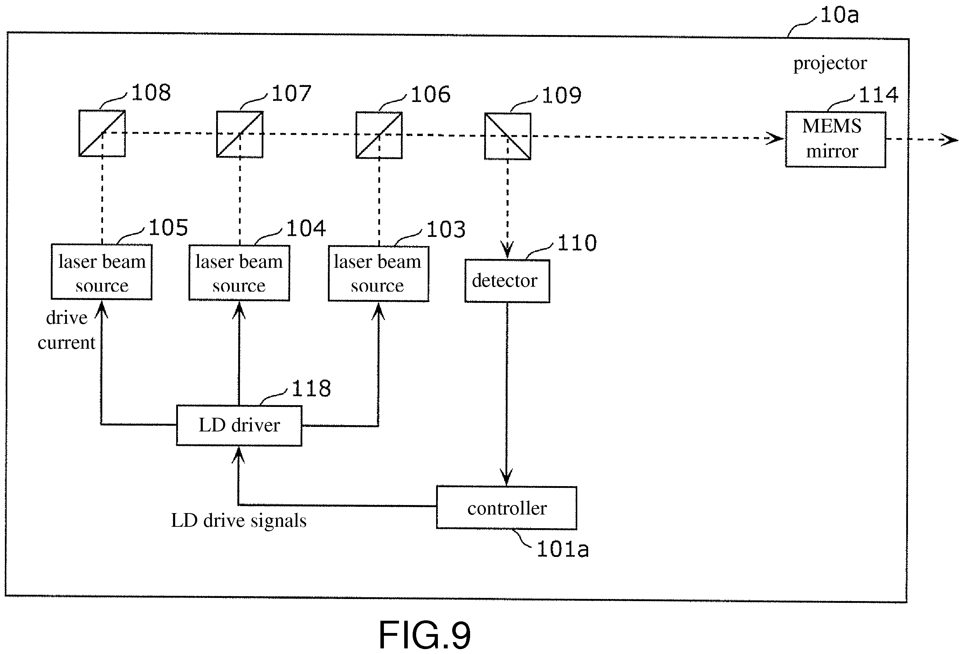

FIG. 9 is a diagram illustrating a configuration example of a HUD device according to the second embodiment. The same reference numerals are used for elements similar to FIG. 3, and detailed descriptions thereof are omitted. In a projector 10a of the second embodiment, the configuration of a controller 101a is different to the projector 10 of the first embodiment.

The controller 101a is, for example, an APC controller and controls the outputs of the laser beam sources 103 to 105, as the same as the first embodiment. The controller 101a controls the LD driver 118 so as to control the irradiation of laser beams emitted from the laser beam sources 103 to 105.

In this embodiment, among a plurality of laser beam sources, the controller 101a pulse-drives a laser beam source having the lowest output with respect to a white balance ratio and a laser beam source having the second-lowest output with respect to the white balance ratio, and continuously drives at least one of the other laser beam sources. Here, for example, the laser beam source having the lowest output is the laser beam source 103 of the blue component, and the laser beam source having the second-lowest output is the laser beam source 104 of the green component. That is, the controller 101a reduces the average (the minimum outputs) of the minimum values of the outputs of the laser beam source 103 and the laser beam source 104 by pulse-driving the laser beam source 103 of the blue component and the laser beam source 104 of the green component among the laser beam sources 103 to 105. Here, the controller 101a pulse-drives the laser beam source 103 with the duty ratio of 0.25, and pulse-drives the laser beam source 104 of the green component with the duty ratio of 0.5, for example.

Operations of Projector

Next, operations of the projector 10a are described. Featured operations among the operations of the projector 10a are mainly described below.

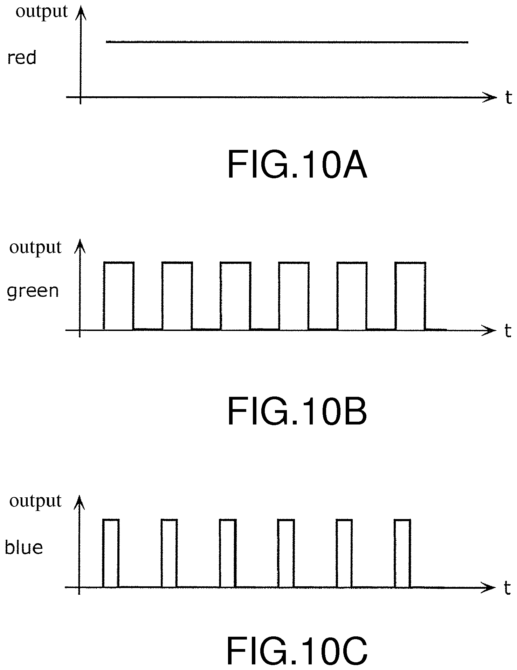

FIG. 10 is a diagram illustrating an example of driving waveforms of the plurality of laser beam sources according to the second embodiment.

In this embodiment, the laser beam source 105 of the red component shown as FIG. 10A is driven by CW (continuous wave), and the laser beam source 104 of the green component shown as FIG. 10B and the laser beam source 103 of the blue component shown as FIG. 10C are pulse-driven.

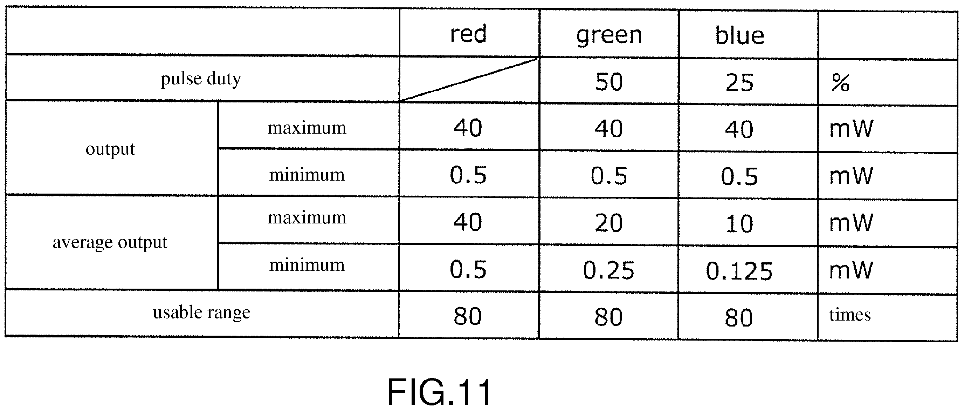

FIG. 10B shows an example that the laser beam source 104 is pulse-driven with a duty ratio of 0.5 (duty 50%), and FIG. 10C shows an example that the laser beam source 103 is pulse-driven with a duty ratio of 0.25 (duty 25%). Such duty ratios are resulted from the configuration that the white balance is constituted by the relationship of the output of red and the average output of green and the average output of blue under the condition that the outputs of the laser beam sources of RGB are maximum (the maximum output). Below is the description using numerical examples shown in FIG. 11.

FIG. 11 is a diagram illustrating an example of usable ranges of the laser beam sources that are pulse-driven according to the second embodiment. FIG. 11 shown a numerical example that the blue component is pulse-driven with a duty 25% and a power 4 times as great as the pulse peak power, and the green component is pulse-driven with a duty 50% and a power 2 times as great as the pulse peak power.

Since the minimum value (the minimum output) of the output of the laser beam source 103 of the blue component is 0.5mW, the minimum output (the average of the minimum values of the output) can be 0.125mW with a duty 25%. Also, the rated output of the laser beam source 103 of the blue component is still capable of being greater in view of the maximum output of 10mW shown in FIG. 5, so the maximum output (the average of the maximum values of the output) can be 10mW by making the maximum output (the maximum pulse peak power) four times, i.e., 40mW. Thereby, the usable range of the laser beam source 103 of the blue component becomes 80 times.

Similarly, the minimum value (the minimum output) of the output of the laser beam source 104 of the green component is 0.5mW as shown in FIG. 5, and the minimum output (the average of the minimum values of the output) can be 0.25mW with a duty 50%. Also, the rated output of the laser beam source 104 of the green component is still capable of being greater in view of the maximum output of 20mW shown in FIG. 5, so the maximum output (the average of the maximum values of the output) can be 20mW by making the maximum output (the maximum pulse peak power) double, i.e., 40mW. Thereby, the usable range of the laser beam source 104 of the green component becomes 80 times. Accordingly, the case with the pulse-driving shown in FIG. 11 can extend the dimmable range to 1/80, compared to the dimmable range 1/20 of the case without the pulse-driving described in FIG. 5.

The laser beam sources 103 and 104 have a rated output, and the maximum output cannot be increased infinitely. For example, when the rated outputs of all the laser beam sources 103 to 105 are 40mW, the pulse-driving as shown in FIG. 11 is possible. That is, as shown in FIG. 11, the usable range of the laser beam sources 103 to 105 can be extended to the maximum and the dimmable range can be extended to the maximum by using the maximum output of the rated output for all the laser beam sources.

Effects

As described above, according to this embodiment, it is possible to realize the projector 10a with which the limitation of the usable range can be eased even laser beam sources of different color components are used and desirable dimming can be performed.

Also, in the projector 10a of this embodiment, the usable range of all the laser beam sources of RGB can be extended to the maximum because the maximum output of the rated output is used for all the laser beam sources of RGB and the light amount of light is reduced by pulse-driving the laser beam sources of GB. Moreover, there is another effect that the control becomes easy since the white balance is obtained when all the laser beam sources of RGB are driven with the maximum output of the rated output.

Third Embodiment

The first and second embodiments describe that the lower-limit value of the average output can be reduced and the apparent threshold value can be reduced by adjusting the duty of the pulse-driven laser beam sources.

However, the threshold value may change with the temperature. That is, the minimum value of the output for each of the laser beam sources of the RGB components also changes with the temperature. Thus, the output may become unstable when the laser beam sources are controlled by the minimum value of the output of laser beam (the same manner as a predetermined temperature) at the temperature different from the predetermined temperature. The predetermined temperature can be for example a normal temperature. When dimming is performed for low luminance under such a condition, a color distortion occurs because the white light cannot be correctly synthesized

In this embodiment, it describes a method and the like to perform dimming for low luminance without color distortion even though the temperature is changed.

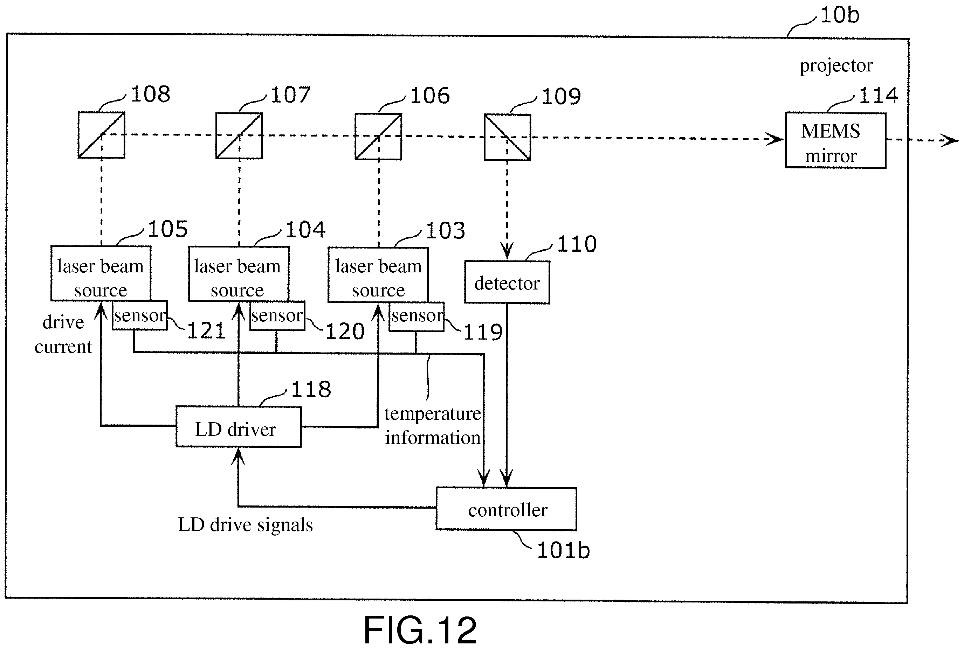

FIG. 12 is a block diagram illustrating a hardware configuration of a HUD device according to the third embodiment. The same reference numerals are used for elements similar to FIG. 3, and detailed descriptions thereof are omitted. In a projector 10b of the third embodiment, the configuration of a controller 101b in which sensors 119 to 121 are added is different from the projector 10 of the first embodiment.

The sensors 119 to 121 are temperature sensors that detect the temperature of the laser beam sources 103 to 105. Each of the sensors 119 to 121 includes, for example, a thermistor. The sensor 119 detects the temperature of the laser beam source 103, the sensor 120 detects the temperature of the laser beam source 104, and the sensor 121 detects the temperature of the laser beam source 105.

The controller 101b is, for example, an APC controller and controls the outputs of the laser beam sources 103 to 105, as the same as the first embodiment. The controller 101b controls the irradiation of laser beams emitted from the laser beam sources 103 to 105 by controlling the LD driver 118.

In this embodiment, the controller 101b obtains the temperature (temperature information) of the laser beam sources 103 to 105 detected by the sensors 119 to 121. The controller 101b changes the peak power and the duty ratio of at least one of the laser beam sources based on the temperature detected by the sensors 119 to 121.

Operations of Projector

Next, operations of the projector 10b are described. Features operations among the operations of the projector 10b are mainly described below.

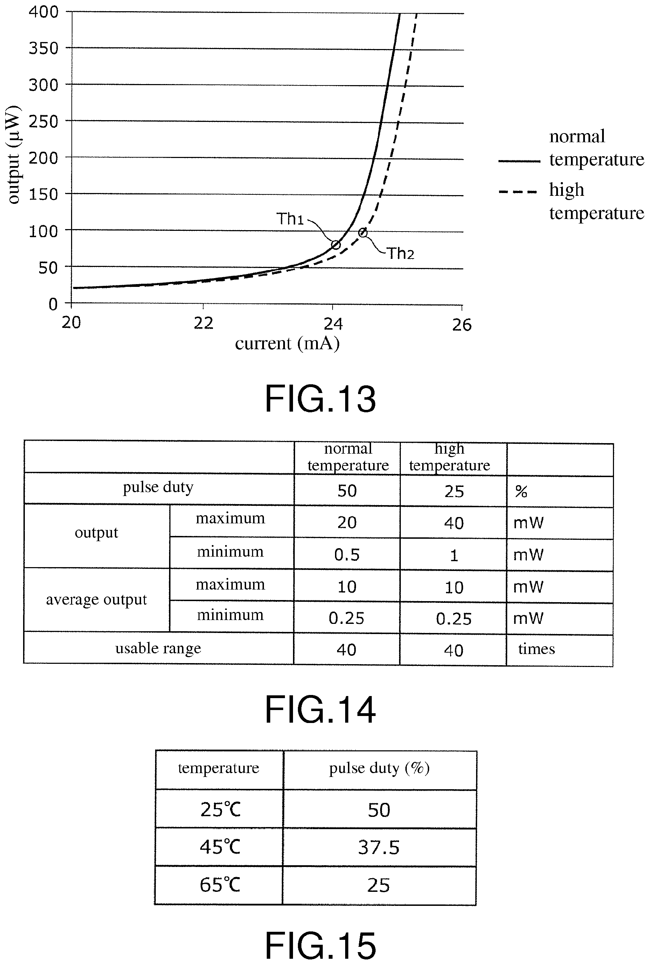

FIG. 13 is a diagram describing the change of the IL characteristic of a laser beam source due to temperature change. FIG. 13 shows the IL characteristic of the laser beam source of blue at a normal temperature (35 degrees Celsius) and at a high temperature (65 degree Celsius) as examples.

As shown in FIG. 13, the IL characteristic of the laser beam source changes according to the temperature, and it can be seen that the threshold value at the high temperature (Th2) is greater than the threshold value at the normal temperature (Th1), and that the minimum output is increased. Namely, the output corresponding to the threshold value Th1 is about $80\mu$W at the normal temperature, and the output corresponding to the threshold value Th2 is increased to about $100\mu$W at the high temperature. It means that, assuming the minimum output at the normal temperature is $100\mu$W, color distortion may occur when the minimum output $100\mu$W is used for dimming for low luminance at the high temperature because the minimum output becomes unstable so that white light cannot be synthesized correctly.

Therefore, in this embodiment, the controller 101b changes the duty of the laser beam sources that are pulse-driven based on the temperature detected by the sensors and controls to avoid the threshold value at the detected temperature. This control is described using FIG. 14.

FIG. 14 is a diagram illustrating numerical examples of duty, etc. at the high temperature according to the third embodiment. FIG. 14 shows numerical examples of a case that the threshold value of the laser beam source 103 of blue rises because of the high temperature. It shows an example that 1mW or higher can be only set as the minimum output (the pulse peak power) at the high temperature in contrast to that 0.5mW or higher can be set as minimum output (the pulse peak power) at the normal temperature. In this case, the controller 101b reduces the duty from 50% at the normal temperature to 25%, and increases the maximum output (the pulse peak power) double. Thereby, it is possible to make the maximum value and the minimum value of the average output to be the same as those at the normal temperature, and to make the usable range to be the same as the usable range at the normal temperature.

FIG. 15 is a diagram illustrating numerical examples of duty adjustment based on the temperature according to the third embodiment.

FIG. 15 shows an example of duty adjustment of the laser beam source 103 of blue at 25 degrees Celsius (the normal temperature), 45 degrees Celsius (the high temperature) and 65 degrees Celsius (the high temperature).

The relationship between the temperature value and the duty as shown in FIG. 15 may be stored in a memory (not depicted) of the projector 10b as a lookup table (LUT) or a formula. The lookup table or the formula differs depend on the laser beam sources, so the relationship between the temperature value and the duty may be stored in the memory for each of the laser beam sources.

The controller 101b adjusts the duty based on the temperature by referring to the lookup table and the like. But, the controller 101b may also adjust the maximum value and the minimum value of the output (the pulse peak power) along with the duty adjustment to make the maximum value and the minimum value of the average output as well as the usable range the same as those at the normal temperature as mentioned above. The controller 101b can calculate the maximum value and the minimum value of the output by using the following formula (1).

$$P_{peakA} = P_{peak100} / (A / 100) \qquad\qquad (1)$$

Here, $P_{peakA}$ represents the maximum output with a duty A%, and $P_{peak100}$ represents the maximum output with a duty 100%.

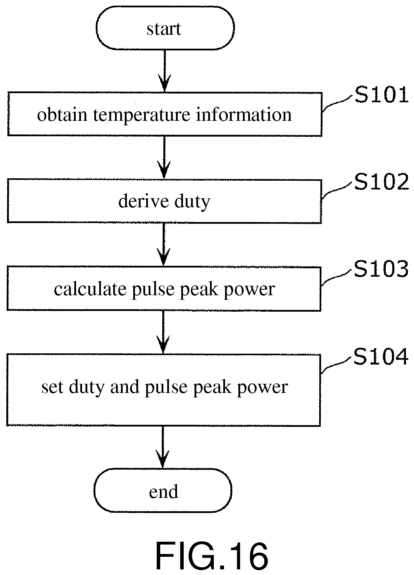

FIG. 16 is a flow chart describing the operations of the projector according to the third embodiment.

Firstly, the controller 101b obtains temperature information of the laser beam sources (S101) from sensors. For example, when the laser beam source 103 of blue component is pulse-driven, the controller 101b obtains the temperature (the temperature information) of the laser beam source 103 from the sensor 119.

Next, the controller 101b derives a duty (S102). For example, when a lookup table or a formula is stored in the memory (not depicted) of the projector 10b, the controller 101b derives a duty corresponding to the obtained temperature by referring to the lookup table or the formula stored in the memory.

Next, the controller 101b calculates pulse peak powers (S103). For example, the controller 101b calculates the pulse peak powers, i.e., the maximum value and minimum value of the output of the laser beam source 103 by using the aforementioned formula (1).

Next, the controller 101b set the calculated pulse peak powers and the derived duty (S103). For example, the controller 101b updates the settings of the laser beam source 103 with the derived maximum value and minimum value of the output of the laser beam source 103 and the calculated duty.

Thereby, the projector 10b can update (adjust) the duty as well as the maximum value and minimum value of the output (the pulse peak powers) based on the temperature of the laser beam sources. This updating procedure may be performed for all the pulse-driven laser beam sources every predetermined time (for example, every 30 seconds, or a time interval within which the temperature change of the laser beam sources can be recognized as minor).

Effects

As described above, according to this embodiment, it is possible to realize the projector 10b with which the limitation of the usable range can be eased even laser beam sources of different color components are used and desirable dimming can be performed.

In this embodiment, the settings (the duty, the average of the maximum values of the output, and the average of the minimum values of the output) of the laser beam sources are updated (adjusted) according to the temperature of the pulse-driven laser beam sources by disposing the sensors which detect the temperature of the laser beam sources. Thereby, the usable range can be the same as the usable range under the normal temperature regardless of temperature.

For example, according to the projector 10b of this embodiment, when the temperature of the pulse-driven laser beam sources rises, the maximum output decreases and the threshold value rises, the duty is reduced to increase the maximum output (the average of the maximum values of the output) and the minimum output (the average of the minimum values of the output). Thereby, the laser beam sources can be controlled within a range including the maximum output even temperature change occurs.

Other Embodiments

The HUD device according to the embodiments of the present invention is described above, but the present invention is not limited thereto.

For example, in the projector 10, specifically, the controller 101 may be configured as a computer system that includes a microprocessor, a ROM, a RAM, a hard disk drive, a display unit, a keyboard and a mouse. The RAM or the hard disk drive stores a computer program. These processing parts achieve their functions by the microprocessor operating according to the computer program. Here, the computer program includes a combination of a plurality of instruction codes indicating instructions to the computer to achieve predetermined functions.

In addition, a part of elements or all elements constituting each of the abovementioned devices may be composed of a single system LSI (Large Scale Integration). A system LSI is a super multifunctional LSI produced by integrating a plurality of components on a single chip, and includes a computer system, consisting of, for example, a microprocessor, ROM, RAM, etc. In this case, the ROM stores a computer program. The system LSI achieves its functions by the microprocessor operating according to the computer program.

Furthermore, a part of elements or all elements constituting each of the abovementioned devices may be composed of an IC card or a single module that is detachable from each of the devices. An IC card or a module is a computer system consisting of a microprocessor, a RAM, a ROM, etc. The IC card or the module may include the abovementioned super multifunctional LSI. The IC card or the module achieves its functions by the microprocessor operating according to the computer program. The IC card or the module may have tamper resistance.

The present invention may be methods shown above. The present invention may be a computer program that implements the methods by a computer or a digital signals consisting of the computer program.

In addition, the present invention may be a computer-readable non-transitory storage medium, such as a flexible disk, a hard disk, a CD-ROM, an MO, a DVD, a DVD-ROM, a DVD-RAM, a BD (Blu-ray (R) Disk), a semiconductor memory, etc. storing the computer program or the digital signals. Also, the present invention may be the digital signals stored in these non-transitory storage media.

Also, the present invention may be the computer program or the digital signals transferred via telecommunication lines, wireless or wired communication lines, a network represented by the Internet, a data broadcast, etc.

Also, the present invention may be a computer system including a microprocessor and a memory. The memory stores the abovementioned computer program, and the microprocessor operates according to the computer program.

Also, the present invention may execute the computer program or the digital signals on another independent computer system by storing the computer program or the digital signals in a non-transitory storage medium and delivering the media, or by transferring the computer program or the digital signals via the network and the like.

In addition, the embodiments and the variation may be respectively combined.

The present invention may be applied as a projector to, for example, a HUD device and the like mounted on an automobile.

Reference numerals

1: HUD device
10, 10a, 10b: projector
20: windshield
50: atomobile
60: combiner
61: route information
62: distance information

101, 101a, 101b: controller
103, 104, 105: laser beam source
106, 107, 108: beam splitter
110: detector
114: MEMS mirror
118: LD driver
119, 120, 121: sensor

**Claims**

1. A projecting device (10), comprising:

   a light source including a plurality of light-emitting parts (103~105) each of which outputs a light beam of a different color component (RGB); and
   a controller (101), configured to control an output of the light source, **characterized in that**
   the controller (101) is configured to, for all outputs of the output ranges of the respective light emitting parts, pulse-drive the light-emitting part having a lowest output among the light-emitting parts, the lowest output being determined based on an output ratio of the light emitting parts for white light as determined by a white balance ratio, and to continuously drive at least one of the plurality of the light-emitting parts (104~105) other than the light-emitting part (103) having the lowest output.

2. The projecting device (10) according to claim 1, **characterized in that** the controller (101) is configured to pulse-drive the light-emitting parts (103~104) respectively having the lowest output and a second lowest output among the light-emitting parts (103~105) based on said output ratio.

3. The projecting device (10) according to any one of claims 1 to 2, **characterized in that** the controller (101) is configured to pulse-drive the light-emitting parts (103~104) respectively having the lowest output and the second lowest output with different duty ratios.

4. The projecting device (10) according to any one of claims 1-3, **characterized in that** the controller (101) is configured to pulse-drive the light-emitting parts (103~104) respectively having the lowest output and the second lowest output with different duty ratios in a manner that a ratio of a maximum value and a minimum value of an average output is equal.

5. The projecting device (10) according to any one of claims 1-4, **characterized in that** the controller (101) is configured to bring minimum values of usable outputs of the plurality of light-emitting parts (103~105) closer together.

6. The projecting device (10) according to any one of claims 1-5, **characterized in that** each of the plurality of light-emitting parts (103~105) is configured to comprise a sensor (119~121) detecting a temperature thereof.

7. The projecting device (10) according to claim 6, **characterized in that** the controller (101) is configured to change a peak power and a duty ratio of the at least one of the plurality of the light emitting parts (103~105) based on the temperature detected by the sensor (119~121).

8. The projecting device (10) according to claim 7, **characterized in that** the controller (101) is configured to change the peak power and the duty ratio every time a predetermined time period passes.

9. The projecting device (10) according to claim 7 or 8, **characterized in that** the controller (101) is configured to change the peak power and the duty ratio by a look-up table.

10. The projecting device (10) according to claim 7 or 8, **characterized in that** the controller (101) is configured to control average outputs of the plurality of the light emitting parts to be the same as average outputs at a predetermined temperature.

11. The projecting device (10) according to claim 10, **characterized in that** the average output comprises a maximum average output and a minimum average output.

12. The projecting device (10) according to any one of claims 1-11, **characterized in that** the color components are a red component (R), a green component (G) and a blue component (B).

13. The projecting device (10) according to claim 12, **characterized in that** the light-emitting part having the lowest output is the light-emitting part of the blue component (B).

14. The projecting device (10) according to claims 12 or 13, **characterized in that** the light-emitting part having the second lowest output is the light-emitting part of the green component (G).

**Patentansprüche**

1. Projektionsvorrichtung (10), umfassend:

   eine Lichtquelle mit einer Vielzahl von lichtemittierenden Teilen (103~105), von denen jeder einen Lichtstrahl einer anderen Farbkomponente (RGB) ausgibt; und
   eine Steuerung (101), die konfiguriert ist, um eine Ausgabe der Lichtquelle zu steuern, **dadurch gekennzeichnet, dass**
   die Steuerung (101) konfiguriert ist, um für alle Ausgaben der Ausgabenbereiche der jeweiligen lichtemittierenden Teile den lichtemittierenden Teil mit der niedrigsten Ausgabe unter den lichtemittierenden Teilen Impuls-anzutreiben, wobei die niedrigste Ausgabe basierend auf einem Ausgabeverhältnis der lichtemittierenden Teile für Weißlicht bestimmt wird, das durch ein Weißabgleich-Verhältnis bestimmt wird, und um mindestens eines der Vielzahl der lichtemittierenden Teile (104~105), das sich von dem lichtemittierenden Teil (103) mit der niedrigsten Ausgabe unterscheidet, kontinuierlich anzutreiben.

2. Projektionsvorrichtung (10) gemäß Anspruch 1, **dadurch gekennzeichnet, dass** die Steuerung (101) konfiguriert ist, um die lichtemittierenden Teile (103~104) mit der jeweils niedrigsten Ausgabe und einer zweitniedrigsten Ausgabe unter den lichtemittierenden Teilen (103~105) basierend auf dem Ausgabeverhältnis Impuls-anzutreiben.

3. Projektionsvorrichtung (10) gemäß irgendeinem der Ansprüche 1 bis 2, **dadurch gekennzeichnet, dass** die Steuerung (101) konfiguriert ist, um die lichtemittierenden Teile (103~104) mit der jeweils niedrigsten Ausgabe und der zweitniedrigsten Ausgabe mit unterschiedlichen Tastverhältnissen Impuls-anzutreiben.

4. Projektionsvorrichtung (10) gemäß irgendeinem der Ansprüche 1-3, **dadurch gekennzeichnet, dass** die Steuerung (101) konfiguriert ist, um die lichtemittierenden Teile (103~104) mit der jeweils niedrigsten Ausgabe und der zweitniedrigsten Ausgabe mit unterschiedlichen Tastverhältnissen in einer Weise Impuls-anzutreiben, dass ein Verhältnis von einem Maximalwert und einem Minimalwert einer durchschnittlichen Ausgabe gleich ist.

5. Projektionsvorrichtung (10) gemäß irgendeinem der Ansprüche 1-4, **dadurch gekennzeichnet, dass** die Steuerung (101) konfiguriert ist, um Minimalwerte von nutzbaren Ausgaben der Vielzahl von lichtemittierenden Teilen (103~105) näher zusammenzubringen.

6. Projektionsvorrichtung (10) gemäß irgendeinem der Ansprüche 1-5, **dadurch gekennzeichnet, dass** jedes der Vielzahl von lichtemittierenden Teilen (103~105) konfiguriert ist, um einen Sensor (119~121) zu umfassen, der eine Temperatur davon erfasst.

7. Projektionsvorrichtung (10) gemäß Anspruch 6, **dadurch gekennzeichnet, dass** die Steuerung (101) konfiguriert ist, um eine Spitzenleistung und ein Tastverhältnis des mindestens einen der Vielzahl der lichtemittierenden Teile (103~105) basierend auf der Temperatur, die vom Sensor (119~121) erfasst wird, zu ändern.

8. Projektionsvorrichtung (10) gemäß Anspruch 7, **dadurch gekennzeichnet, dass** die Steuerung (101) konfiguriert ist, um die Spitzenleistung und das Tastverhältnis jedes Mal zu ändern, wenn eine vorbestimmte Zeitspanne vergeht.

9. Projektionsvorrichtung (10) gemäß Anspruch 7 oder 8, **dadurch gekennzeichnet, dass** die Steuerung (101) konfiguriert ist, um die Spitzenleistung und das Tastverhältnis über eine Nachschlagetabelle zu ändern.

10. Projektionsvorrichtung (10) gemäß Anspruch 7 oder 8, **dadurch gekennzeichnet, dass** die Steuerung (101) konfiguriert ist, um Durchschnittsausgaben der Vielzahl der lichtemittierenden Teile zu steuern, um gleich wie die Durchschnittsausgaben bei einer vorbestimmten Temperatur zu sein.

**11.** Projektionsvorrichtung (10) gemäß Anspruch 10, **dadurch gekennzeichnet, dass** die Durchschnittsausgabe eine maximale Durchschnittsausgabe und eine minimale Durchschnittsausgabe umfasst.

**12.** Projektionsvorrichtung (10) gemäß irgendeinem der Ansprüche 1-11, **dadurch gekennzeichnet, dass** die Farbkomponenten eine rote Komponente (R), eine grüne Komponente (G) und eine blaue Komponente (B) aufweisen.

**13.** Projektionsvorrichtung (10) gemäß Anspruch 12, **dadurch gekennzeichnet, dass** der lichtemittierende Teil mit der geringsten Ausgabe der lichtemittierende Teil der blauen Komponente (B) ist.

**14.** Projektionsvorrichtung (10) gemäß den Ansprüchen 12 oder 13, **dadurch gekennzeichnet, dass** der lichtemittierende Teil mit der zweitniedrigsten Ausgabe der lichtemittierende Teil der grünen Komponente (G) ist.

## Revendications

**1.** Dispositif de projection (10), comprenant :

une source lumineuse incluant une pluralité de pièces émettrices de lumière (103-105) dont chacune émet un faisceau lumineux d'un composant coloré différent (RGB) ; et
une commande (101) conçue pour commander une émission de la source lumineuse, **caractérisé en ce que** la commande (101) est conçue pour, pour toutes les émissions des plages d'émission des pièces émettrices de lumière respectives, entraîner par impulsion la pièce émettrice de lumière ayant une émission la plus faible parmi les pièces émettrices de lumière, l'émission la plus faible étant déterminée à partir d'un ratio d'émission des pièces d'émission de lumière pour la lumière blanche tel que déterminé par un ratio d'équilibre de blanc, et pour entraîner continûment au moins une de la pluralité de pièces émettrices de lumière (104-105) autre que la pièce émettrice de lumière (103) ayant l'émission la plus faible.

**2.** Dispositif de projection (10) selon la revendication 1, **caractérisé en ce que** la commande (101) est conçue pour entraîner par impulsion les pièces émettrices de lumière (103-104) ayant respectivement l'émission la plus faible et une seconde émission la plus faible parmi les pièces émettrices de lumière (103-105) en se basant sur ledit ratio d'émission.

**3.** Dispositif de projection (10) selon la revendication 1 à 2, **caractérisé en ce que** la commande (101) est conçue pour entraîner par impulsion les pièces émettrices de lumière (103-104) ayant l'émission la plus faible et la seconde émission la plus faible avec différents ratios de charge.

**4.** Dispositif de projection (10) selon la revendication 1 à 3, **caractérisé en ce que** la commande (101) est conçue pour entraîner par impulsion les pièces émettrices de lumière (103-104) ayant respectivement l'émission la plus faible et la seconde émission la plus faible avec différents ratios de charge de manière à ce qu'un ratio d'une valeur maximale et d'une valeur minimale d'une émission moyenne soit égal.

**5.** Dispositif de projection (10) selon la revendication 1 à 4, **caractérisé en ce que** la commande (101) est conçue pour rapprocher des valeurs minimales d'émissions utilisables de la pluralité de pièces émettrices de lumière (103-105) les unes des autres.

**6.** Dispositif de projection (10) selon la revendication 1 à 5, **caractérisé en ce que** chacune de la pluralité de pièces émettrices de lumière (103-105) est conçue pour comprendre un capteur (119-121) détectant sa température.

**7.** Dispositif de projection (10) selon la revendication 6, **caractérisé en ce que** la commande (101) est conçue pour changer une crête de puissance et un ratio de charge de l'au moins une de la pluralité de pièces émettrices de lumière (103-105) en se basant sur la température détectée par le capteur (119-121).

**8.** Dispositif de projection (10) selon la revendication 7, **caractérisé en ce que** la commande (101) est conçue pour changer la crête de puissance et le ratio de charge chaque fois qu'une période prédéterminée s'écoule.

**9.** Dispositif de projection (10) selon la revendication 7 ou 8, **caractérisé en ce que** la commande (101) est conçue pour changer la crête de puissance et le ratio de charge par un tableau de recherche.

10. Dispositif de projection (10) selon la revendication 7 ou 8, **caractérisé en ce que** la commande (101) est conçue pour contrôler les émissions moyennes de la pluralité de pièces émettrices de lumière de manière à ce qu'elles soient les mêmes que les émissions moyennes à une température prédéterminée.

11. Dispositif de projection (10) selon la revendication 10, **caractérisé en ce que** l'émission moyenne comprend une émission moyenne maximale et une émission moyenne minimale.

12. Dispositif de projection (10) selon l'une des revendications 1 à 11, **caractérisé en ce que** les composants colorés sont un composant rouge (R), un composant vert (G) et un composant bleu (B).

13. Dispositif de projection (10) selon la revendication 12, **caractérisé en ce que** la pièce émettrice de lumière ayant la plus faible émission est la pièce émettrice de lumière du composant bleu (B).

14. Dispositif de projection (10) selon la revendication 12 ou 13, **caractérisé en ce que** de la pièce émettrice de lumière ayant la seconde plus faible émission est la pièce émettrice de lumière du composant vert (G).

FIG.1

FIG.2

FIG.3

EP 3 179 717 B1

| | R | G | B |
|---|---|---|---|
| wavelength (nm) | 650 | 513 | 456 |
| white balance ratio | 4.1 | 1.8 | 1.0 |

# FIG.4

|  | | red | green | blue | |
|---|---|---|---|---|---|
| output | maximum | 40 | 20 | 10 | mW |
| | minimum | 0.5 | 0.5 | 0.5 | mW |
| usable range | | 80 | 40 | 20 | times |

FIG.5

EP 3 179 717 B1

| | | red | green | blue | |
|---|---|---|---|---|---|
| pulse duty | | | | 50 | % |
| output | maximum | 40 | 20 | 20 | mW |
| | minimum | 0.5 | 0.5 | 0.5 | mW |
| average output | maximum | 40 | 20 | 10 | mW |
| | minimum | 0.5 | 0.5 | 0.25 | mW |
| usable range | | 80 | 40 | 40 | times |

FIG.6

FIG.7A

FIG.7B

FIG.7C

FIG.8

EP 3 179 717 B1

FIG.9

red

FIG.10A

green

FIG.10B

blue

t

FIG.10C

| | red | green | blue | |
|---|---|---|---|---|
| pulse duty | | 50 | 25 | % |
| output | maximum | 40 | 40 | 40 | mW |
| | minimum | 0.5 | 0.5 | 0.5 | mW |
| average output | maximum | 40 | 20 | 10 | mW |
| | minimum | 0.5 | 0.25 | 0.125 | mW |
| usable range | 80 | 80 | 80 | times |

FIG.11

FIG.12

EP 3 179 717 B1

**FIG.13**

|  |  | normal temperature | high temperature |  |
|---|---|:---:|:---:|:---:|
| pulse duty |  | 50 | 25 | % |
| output | maximum | 20 | 40 | mW |
|  | minimum | 0.5 | 1 | mW |
| average output | maximum | 10 | 10 | mW |
|  | minimum | 0.25 | 0.25 | mW |
| usable range |  | 40 | 40 | times |

**FIG.14**

| temperature | pulse duty (%) |
|:---:|:---:|
| 25℃ | 50 |
| 45℃ | 37.5 |
| 65℃ | 25 |

**FIG.15**

start

obtain temperature information — S101

derive duty — S102

calculate pulse peak power — S103

set duty and pulse peak power — S104

end

# FIG.16

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009094315 A
- US 2015333478 A1
- US 2015260984 A1